# EUROPÄISCHE PATENTSCHRIFT

(11) **EP 4 020 742 B1**
(45) Veröffentlichungstag und Bekanntmachung des Hinweises auf die Patenterteilung: **18.11.2026**
(21) Anmeldenummer: 20217430.6
(22) Anmeldetag: 28.12.2020
(51) Int. Cl.: F03D 7/02, F03D 7/04, H02J 3/38, H02J 13/12, H02J 3/46, G01R 21/00

(54) **VERFAHREN ZUM BESTIMMEN EINER VERFÜGBAREN LEISTUNG UND EINER VERLUSTLEISTUNG EINES WINDPARKS**
METHOD FOR DETERMINING AN AVAILABLE POWER AND A POWER LOSS OF A WIND PARK
PROCÉDÉ DE DETERMINATION D'UNE PUISSANCE DISPONIBLE ET D'UNE PERTE DE PUISSANCE D'UN PARC D'EOLIENNES

(43) Veröffentlichungstag der Anmeldung: 29.06.2022
(73) Patentinhaber: Wobben Properties GmbH, 26607 Aurich (DE)
(72) Erfinder: Brombach, Johannes, 13437 Berlin (DE); Emanuel, Hanna, 28203 Bremen (DE)
(74) Vertreter: Eisenführ Speiser

(56) Entgegenhaltungen:
- DE-A1- 102011 112 025
- ES-T3- 2 647 217
- US-A1- 2015 267 683
- GUPTA AKHILESH PRAKASH ET AL: "Apparent Power Loss Based Equivalent Model of Wind Farm Collector System", 2018 20TH NATIONAL POWER SYSTEMS CONFERENCE (NPSC), IEEE, 14 December 2018 (2018-12-14), pages 1 - 6, XP033578938, DOI: 10.1109/NPSC.2018.8771713

## Beschreibung

Die vorliegende Erfindung betrifft ein Verfahren zum Bestimmen einer Verlustleistung eines Windparks sowie einen hiermit gesteuerten Windpark.

Windparks weisen üblicherweise eine Vielzahl von Windenergieanlagen auf, die über ein gemeinsames Windparknetz miteinander verbunden sind und über eine Vielzahl von Signalen gesteuert werden, bspw. mittels einer Windparksteuereinheit.

Eines dieser Signale ist die sogenannte verfügbare Leistung, die angibt, wieviel Leistung ein Windpark bzw. eine einzelne Windenergieanlage unter Berücksichtigung eines vorherrschenden Windes produzieren kann.

Mittels dieses Signals der verfügbaren Leistung können Windparks insbesondere ertragsoptimierter betrieben werden, bspw. für die Bereitstellung von Regelleistung und/oder für die Direktvermarktung.

Nachteilig bei bisher bekannten Verfahren zum Bestimmen einer verfügbaren Leistung eines Windparks ist, dass die Berechnung ausschließlich über einen vorherrschenden Wind erfolgt DE 10 2011 112 025 A1 beschreibt einen Windpark mit mindestens zwei Windenergieanlagen, die jeweils einen Generator mit einem Umrichter zur Erzeugung elektrischer Energie und eine Betriebssteuerung mit einem Blindleistungsregler aufweisen, wobei eine schnelle Spannungsregelung vorgeschlagen wird.

Der Artikel von Akhilesh Prakash Gupta u.a.: "Apparent Power Loss Based Equivalent Model of Wind Farm Collector System", 2018 20th NATIONAL POWER SYSTEMS CONFERENCE (NPSC), IEEE, 14. Dezember 2018, Seiten 1 -6, beschreibt ein auf Scheinleistungsverlusten basierendes Äquivalenzmodell für das Kollektorsystem eines Windparks, das die Blindleistungsgrenzen der einzelnen Windturbinen und den Nachlaufeffekt im Windpark berücksichtigt.

US 2015/267683 A1 betrifft ein Verfahren zum Betreiben eines Windparks und einen Windpark.

Aufgabe der vorliegenden Erfindung ist es daher ein verbessertes Signal für die verfügbare Leistung eines Windparks bereitzustellen, insbesondere soll dieses Signal auch die etwaigen Verluste eines Windparks berücksichtigen.

Erfindungsgemäß wird somit ein Verfahren gemäß Anspruch 1 zum Bestimmen einer verfügbaren Leistung und einer Verlustleistung eines an einem Netzanschlusspunkt eines elektrischen Versorgungsnetzes angeschlossenen Windparks vorgeschlagen, wobei der Windpark eine Vielzahl von Windenergieanlagen aufweist, die gemeinsam über ein elektrisches Windparknetz verbunden sind und jeweils einen Umrichter zum Einspeisen elektrischer Leistung in das elektrische Windparknetz aufweisen.

In einem ersten Schritt wird ein, durch den Windpark einzuspeisender Strom, insbesondere am Netzanschlusspunkt des Windparks bestimmt. Dies kann bspw. durch eine Messung direkt am Netzanschlusspunkt erfolgen und/oder durch Berechnung.

In einem weiteren Schritt wird der Widerstand des Windparks bestimmt.

Es wird also der Widerstand für den Windpark bestimmt, der den einzuspeisenden Strom erzeugt und am Netzanschlusspunkt einspeist.

Der Widerstand ergibt sich üblicherweise aus der Topologie des Windparks und gibt den elektrischen Gesamtwiderstand für den Windpark vom Netzanschlusspunkt aus an, bspw. bis hin zu den Umrichterklemmen der Windenergieanlagen.

Bevorzugt ist der Widerstand des Windparks eine Impedanz.

In einem letzten Schritt wird die Verlustleistung des Windparks unter Berücksichtigung des einzuspeisenden Stromes und des Windparkwiderstands bestimmt.

Es wird also insbesondere vorgeschlagen, bei der Bestimmung der Verlustleistung des Windparks, die Verlustleistung des Windparknetzes zu berücksichtigen.

Auch können zur Bestimmung der Verlustleistung des Windparks, neben der Verlustleistung des Windparknetzes, die zusätzlichen Umrichterverluste der Windenergieanlagen berücksichtigt werden.

Zudem wird insbesondere auch vorgeschlagen, die Verlustleistung des Windparks mittels eines vereinfachten Ersatzschaltbildes, bevorzugt eines einpoligen Ersatzschaltbildes, zu bestimmen.

Das vereinfachte Ersatzschaltbild bildet dabei insbesondere das Windparknetz ab.

In einer weiteren Ausführungsform wird die Windparkladeleistung bzw. die Windparkkapazität bei der Bestimmung der Verlustleistung des Windparks berücksichtigt.

Unter einer Ladeleistung wird dabei insbesondere jene Blindleistung verstanden, die ein elektrisches Bauteil aufnimmt. Die Windparkladeleistung beschreibt also insbesondere jene Leistung, die das Windparknetz aufnimmt, insbesondere bei einer Einspeisung von Null Wirkleistung aufnimmt.

Durch die Verwendung eines vereinfachten Ersatzschaltbildes ist es insbesondere möglich, die Verlustleistung so zu bestimmen, dass keine aufwendige Soft- und Hardware nötig ist, wie bspw. bei einer komplexen Lastflussrechnung.

Das Verfahren ermöglicht also insbesondere die Verlustleistung eines Windparks mit einmaliger Berechnung zu ermitteln, insbesondere also kein iteratives Verfahren, wie bei einer komplizierten Lastflussberechnung, zu verwenden.

Auf Grund der Verwendung eines vereinfachten Ersatzschalbildes, kann das Verfahren zum Bestimmen der Verlustleistung linearisiert und somit stark vereinfacht und dadurch auf jeder Windparksteuereinheit ausgeführt werden.

Dies wäre bspw. bei einer vollständigen Betrachtung der Netzverluste durch eine iterative Lastflussberechnung auf Basis einer Einspeiseprognose nicht möglich, da hierfür eine aufwendige Hard- und/oder Softwarelösung nötig wäre, über die üblicherweise nur der Netzbetreiber verfügt.

Das vorstehend und/oder nachstehend beschriebene Verfahren ist also insbesondere dazu geeignet, auf einer, insbesondere üblichen, Windparksteuereinheit ausgeführt zu werden.

Vorzugsweise umfasst das Verfahren ferner den Schritt: Bestimmen einer verfügbaren Leistung des Windparks, insbesondere unter Berücksichtigung eines vorherrschenden Windes und wobei der einzuspeisende Strom in Abhängigkeit der verfügbaren Leistung des Windparks bestimmt wird.

Um die verfügbare Leistung des Windparks zu bestimmen, wird also vorgeschlagen, bspw. auf den vorherrschenden Wind zurückzugreifen, bspw. durch ein Anemometer oder LIDAR-System im Windpark.

Aus dem so ermittelten vorherrschenden Wind kann dann bspw. mittels bautechnischer Parameter der Windenergieanlage die verfügbare Leistung der Windenergieanlage berechnet werden, bspw. kann anhand des vorherrschenden Windes, der Windklasse des Windparks bzw. der Windenergieanlagen des Windparks und der Nennleistung des Windparks bzw. der Windenergieanlagen, dann die verfügbare Leistung des Windparks bestimmt werden.

Die verfügbare Leistung des Windparks kann dabei bspw.:
- durch Aufsummierung der einzelnen verfügbaren Leistungen der Windenergieanlagen bestimmt werden oder
- aus einer verfügbaren Leistung einer Referenz-Windenergieanlage extrapoliert werden oder
- aus der Nennleistung des Windparks, der eingespeisten Leistung des Windparks und einem vorherrschenden Wind abgeleitet werden.

Alternativ kann die verfügbare Leistung der Windenergieanlage bzw. des Windparks auch aus Betriebsdaten der Windenergieanlage abgeleitet werden, bspw. mittels eines Windschätzers und einer rotoreffektiven Windgeschwindigkeit.

Der einzuspeisende Strom und somit die Verlustleistung werden also in Abhängigkeit der verfügbaren Leistung des Windparks bestimmt, die bevorzugt auf Basis eines vorherrschenden Windes bestimmt wurden.

Vorzugsweise umfasst das Verfahren ferner den Schritt: Bestimmen einer Spannung am Netzanschlusspunkt; und wobei der einzuspeisende Strom in Abhängigkeit der Spannung am Netzanschlusspunkt bestimmt wird.

Es wird insbesondere auch vorgeschlagen, beim Bestimmen des einzuspeisenden Stromes auch die Klemmspannung des Windparks zu berücksichtigen, also jene Spannung, die der Windpark am Netzanschlusspunkt aufweist, insbesondere wenn der Windpark die mögliche verfügbare Leistung einspeisen würde.

Es wird also insbesondere auch vorgeschlagen, die Spannung für die mögliche verfügbare Leistung abzuschätzen bzw. zu berechnen, dies kann bspw. mittels einer Look-Up-Tabelle erfolgen, bei die verfügbare Leistung über der Spannung abgetragen ist.

Die Spannung am Netzanschlusspunkt, kann bspw. direkt am Netzanschlusspunkt gemessen werden, oder beim Netzbetreiber angefragt werden und/oder als Sollwert vorgegeben werden.

Vorzugsweise beschreibt der Windparkwiderstand den Windpark vom Netzanschlusspunkt aus.

Es wird also insbesondere vorgeschlagen, den Windpark als solches in einem Ersatzschaltbild vom Netzanschlusspunkt aus zusammenzufassen, bspw. bis hin zu den Umrichterklemmen der Windenergieanlagen.

Vorzugsweise erfolgt das Bestimmen der Verlustleistung des Windparks unter Verwendung eines vereinfachten Ersatzschaltbildes, insbesondere einem einphasigen Ersatzschaltbild.

Es wird also insbesondere vorgeschlagen, den Windpark, insbesondere das Windparknetz, mittels eines vereinfachten Ersatzschaltbildes zu betrachten und auf dieser Basis die Verlustleistung des Windparks zu bestimmen.

Darüber hinaus können zur Berechnung der Verlustleistung des Windparks auch die zusätzlichen Umrichterverluste der Windenergieanlagen berücksichtigt werden.

Vorzugsweise erfolgt das Bestimmen der Verlustleistung des Windparks unter Berücksichtigung eines Blindleistungsarbeitspunktes des Windparks.

Es wird also insbesondere auch vorgeschlagen, den Arbeitspunkt des Windparks zu berücksichtigen, insbesondere den Blindleistungsarbeitspunkt des Windparks bei der Berechnung der Verlustleistung des Windparks zu berücksichtigen.

Der Blindleistungsarbeitspunkt ist dabei bevorzugt der Arbeitspunkt des Windparks bei einer maximalen potentiellen Wirkleistung des Windparks.

Der Blindleistungsarbeitspunkt wird bspw. geschätzt oder berechnet, insbesondere in Abhängigkeit der Fahrweise des Windparks, bspw. einer cos(φ)-Regelung oder einer Q(U)-Regelung.

Bevorzugt wird der Blindleistungsarbeitspunkt hierfür aus einer Look-Up-Tabelle abgelesen.

Der Blindleistungsarbeitspunkt des Windparks kann bspw. aus Sollvorgaben des Netzbetreibers für den Netzanschlusspunkt, insbesondere unter Berücksichtigung einer verfügbaren Leistung des Windparks am Netzanschlusspunkt, bestimmt werden, insbesondere aus:
- einem Blindleistungssollwert für den Windpark am Netzanschlusspunkt oder
- einem cos(phi) für den Windpark am Netzanschlusspunkt oder
- einer Q(U)-Kennlinie für den Windpark am Netzanschlusspunkt, wobei die Q(U)-Kennlinie eine Blindleistungs-Spannungs-Kennlinie für den Windpark am Netzanschlusspunkt ist.

Bevorzugt wird neben der verfügbaren Leistung und dem Blindleistungsarbeitspunkt auch ein Blindleistungsbedarf des elektrischen Windparknetzes bestimmt, und bei der Berechnung der Verlustleistung berücksichtigt.

Vorzugsweise erfolgt das Bestimmen der Verlustleistung des Windparks unter Berücksichtigung einer Spannungssensitivität, insbesondere am Netzanschlusspunkt.

Es wird also insbesondere auch vorgeschlagen, das Verhalten des Windparks am Netzanschlusspunkt zu berücksichtigen.

Hierfür wird, insbesondere, der vom Windpark einzuspeisende Strom am Netzanschlusspunkt berechnet.

Durch diesen einzuspeisenden Strom kann es bspw. zu einer Spannungsänderung am Netzanschlusspunkt kommen, die ebenfalls zu berücksichtigen ist.

Insoweit wird insbesondere vorgeschlagen, den einzuspeisenden Strom am Netzanschlusspunkt in Abhängigkeit der Spannung am Netzanschlusspunkt in Abhängigkeit der einzuspeisenden Wirkleistung am Netzanschlusspunkt zu bestimmen.

Vorzugsweise erfolgt das Bestimmen der Verlustleistung des Windparks für eine Ladeblindleistung bei Null Wirkleistung.

Es wird also insbesondere vorgeschlagen, als Grundlage für die Bestimmung der Verlustleistung ein einphasiges, unbelastetes Ersatzschaltbild zu verwenden und hierdurch das Verhalten des Windparks linearisiert abzubilden.

Zudem werden von einer Linearisierung stark abweichende Effekte, wie bspw. die Spannungssensitivität am Netzanschlusspunkt, gesondert berücksichtigt.

Vorzugsweise erfolgt das Bestimmen der Verlustleistung des Windparks auch unter Berücksichtigung der zusätzlichen Umrichterverluste der Windenergieanlagen.

Unter den zusätzlichen Umrichterverlusten sind dabei insbesondere die zusätzlichen blindleistungsbedingten Umrichterverluste zu verstehen.

Darüber hinaus variiert bspw. der Blindleistungsbedarf des Parknetzes in Abhängigkeit des Wirkleistungsarbeitspunktes zwischen einem kapazitiven Blindleistungsbezug bei Null Wirkleistung von z.B. ca 5 % kapazitiv (bezogen auf den Betrag der maximalen Wirkleistung) und 15 % induktiv bei maximaler Wirkleistung. Wenn also bspw. die Blindleistung am Netzanschlusspunkt Null sein soll, müssen die Windenergieanlagen je nach Arbeitspunkt zwischen 5 % induktiv und 15 % kapazitiv Blindleistung ausbringen.

Es wird also insbesondere vorgeschlagen, neben den Verlusten des Windparknetzes selbst auch die zusätzlichen Verluste durch die Umrichter der Windenergieanlagen zu berücksichtigen.

Bei diesen zusätzlichen Verlusten der Umrichter handelt es sich bevorzugt um blindleistungsbedingte Umrichterverluste.

Die zusätzlichen Umrichterverluste können bspw. aus einer Look-Up-Tabelle oder durch Berechnung bestimmt werden.

Bevorzugt werden die zusätzlichen Umrichterverluste durch Berechnung bestimmt, bspw. mittels einer, insbesondere linearisierten, Gleichung.

Aus den so bestimmten Werten wird abschließend die Verlustleistung des Windparks bestimmt.

Auch kann hierfür bspw. der Windparkwiderstand oder ein Parkfaktor verwendet werden.

Erfindungsgemäß wird ferner ein Verfahren zum Bestimmen einer verfügbaren Leistung eines, eine Vielzahl von Windenergieanlagen aufweisenden Windparks vorgeschlagen, umfassend die Schritte: Bestimmen einer verfügbaren Leistung der Windenergieanlagen unter Berücksichtigung eines vorherrschenden Windes; Berechnen der verfügbaren Leistung des Windparks unter Verwendung der verfügbaren Wirkleistung der Windenergieanlagen und einer Verlustleistung des Windparks, die mit einem vorstehend oder nachstehend beschriebenen Verfahren bestimmt wurde.

Es wird also insbesondere vorgeschlagen, aus der vorstehend oder nachstehend beschriebenen und ermittelten Verlustleistung des Windparks die verfügbare Leistung des Windparks zu berechnen.

Diese so ermittelte verfügbare Leistung des Windparks ist um ein vielfaches genauer als bisher bekannte Verfahren und kann bspw. an einen Netzbetreiber für die Bereitstellung von Regelleistung und/oder für die Direktvermarktung übermittelt werden.

Hierdurch können Windparks ertragsoptimierter betrieben werden, insbesondere, da mit den vorstehend oder nachstehend beschriebenen Verfahren die Arbeitspunkte eines Windparks genauer beschrieben werden können.

Vorzugsweise erfolgt das Berechnen der verfügbaren Leistung des Windparks auch unter Berücksichtigung einer verfügbaren Wirkleistung der Windenergieanlagen.

Erfindungsgemäß wird ferner auch ein Verfahren zum Steuern eines Windparks vorgeschlagen, umfassend die Schritte: Steuern des Windparks unter Berücksichtigung einer verfügbaren Leistung des Windparks, die nach einem vorstehend oder nachstehend beschriebenen Verfahren ermittelt wurde.

Es wird somit insbesondere auch vorgeschlagen, Windparks unter Berücksichtigung einer so ermittelten verfügbaren Leistung zu betreiben, insbesondere ertragsoptimiert zu betreiben.

Erfindungsgemäß wird ferner ein Windpark vorgeschlagen, der eine Vielzahl von Windenergieanlagen und eine Windparksteuereinheit umfasst, wobei die Windparksteuereinheit dazu eingerichtet ist, wenigstens eines der vorstehend oder nachstehend beschriebenen Verfahren auszuführen.

Der Windpark weist also bspw. eine Vielzahl von Windenergieanlagen auf, die über ein gemeinsames Windparknetz miteinander verbunden sind.

Bevorzugt weisen diese Windenergieanlagen jeweils einen Umrichter auf, mittels dem die Windenergieanlagen elektrische Leistung in das elektrische Windparknetz einspeisen.

Weiter bevorzugt weisen die Windenergieanlagen zudem wenigstens eine Windenergieanlagensteuereinheit auf, mittels derer die Windenergieanlage gesteuert wird.

Bevorzugt ist der Windpark zudem über einen Transformator, insbesondere am Netzanschlusspunkt, mit dem elektrischen Versorgungsnetz verbunden.

Weiter bevorzugt weist der Windpark ferner eine Windparksteuereinheit auf, die dazu eingerichtet ist, die Windenergieanlagen über die Windenergieanlagensteuereinheiten zu steuern.

Vorzugsweise weist die Windparksteuereinheit zudem wenigstens eine Look-Up-Tabelle auf.

Die Look-Up-Tabelle kann bspw. dazu verwendet werden, einen Blindleistungsarbeitspunkt des Windparks, eine Spannung des Windparks am Netzanschlusspunkt und/oder die zusätzlichen Umrichterverluste zu bestimmen-

Die Look-Up-Tabelle ist dabei bspw. so aufgebaut, dass ein relativer Arbeitspunkt der Wirkleistung (vorzugsweise in 1 % Schritten) und ein relativer Arbeitspunkt der Blindleistung (vorzugsweise in 1 % Schritten) abgelesen werden können, insbesondere, um im Ergebnis die zusätzlichen relativen Verluste aufgrund des Blindleistungsarbeitspunktes zu bestimmen.

Die Look-Up-Tabelle kann bspw. über Messungen am Umrichterschrank einer bzw. der Windenergieanlagen oder an den Klemmen einer Windenergieanlage oder am Netzanschlusspunkt oder über Modelle bestimmt werden.

Die vorliegende Erfindung wird nun nachfolgend exemplarisch und anhand von Ausführungsbeispielen unter Bezugnahme auf die begleitenden Figuren näher erläutert, wobei für gleiche oder ähnliche Bauteile gleiche Bezugszeichen verwendet werden. Hierbei zeigen:
- Fig. 1: schematisch und exemplarisch eine perspektivische Ansicht einer Windenergieanlage in einer Ausführungsform;
- Fig. 2: schematisch und exemplarisch den Aufbau eines Windparks;
- Fig. 3: schematisch und exemplarisch den Ablauf eines Verfahrens zum Bestimmen einer Verlustleistung;
- Fig. 4: schematisch und exemplarisch ein vereinfachtes Ersatzschaltbild eines Windparks;
- Fig. 5: schematisch und exemplarisch den Ablauf eines Verfahrens zum Bestimmen einer verfügbaren Leistung in einer bevorzugten Ausführungsform.

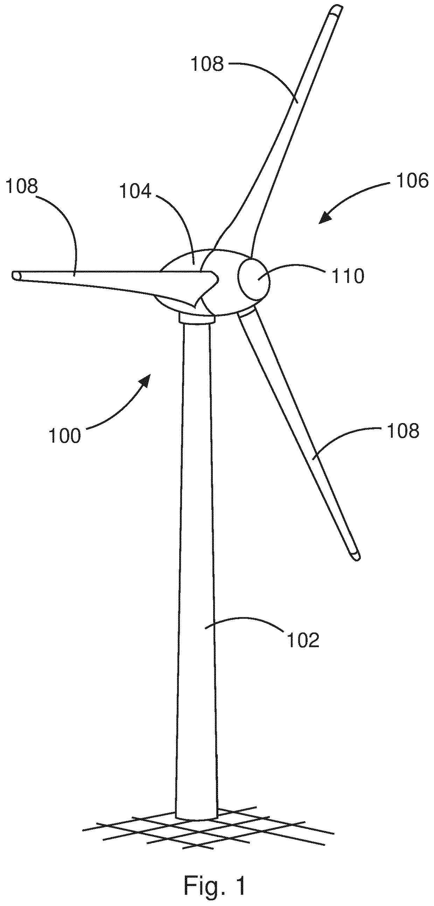

Fig.1 zeigt schematisch und exemplarisch eine perspektivische Ansicht einer Windenergieanlage 100 in einer Ausführungsform.

Die Windenergieanlage 100 weist einen Turm 102 und eine Gondel 104 auf.

An der Gondel 104 ist ein aerodynamischer Rotor 106 mit drei Rotorblättern 108 und einem Spinner 110 angeordnet.

Der Rotor 106 wird im Betrieb durch den Wind in eine Drehbewegung versetzt und treibt dadurch einen Generator in der Gondel an.

Der Generator erzeugt hierdurch einen einzuspeisenden Strom, der mittels eines Umrichters in ein elektrisches Windparknetz oder ein elektrisches Versorgungsnetz eingespeist wird.

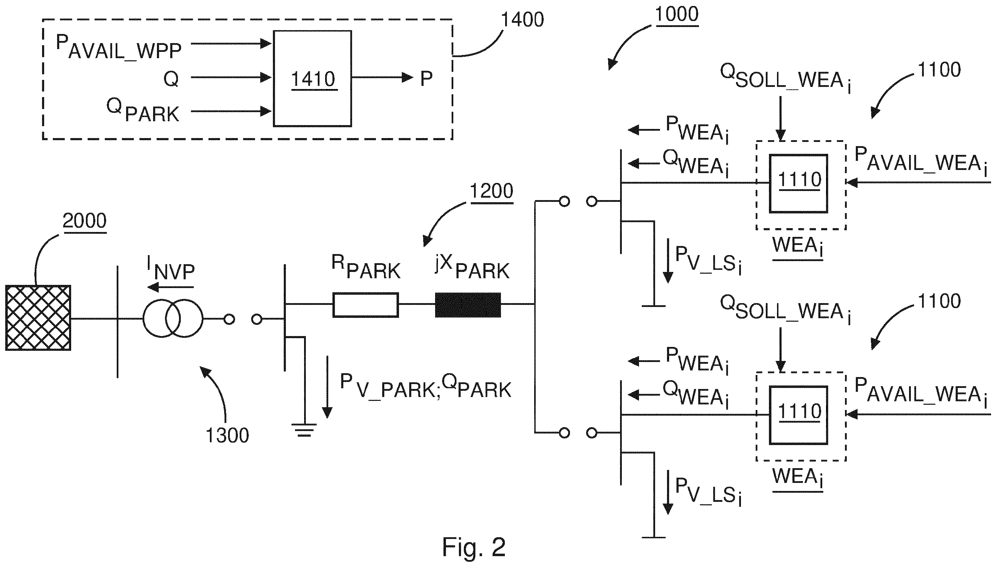

Fig. 2 zeigt schematisch und exemplarisch den Aufbau eines Windparks 1000, insbesondere in Form eines Ersatzschaltbildes.

Der Windpark 1000 weist eine Vielzahl von Windenergieanlagen 1100 auf, die über ein gemeinsames Windparknetz 1200 miteinander verbunden sind.

Der Windpark 1000 ist über einen Netzanschlusspunkt 1300 mit einem elektrischen Versorgungsnetz 2000 verbunden und wird mittels einer Windparksteuereinheit 1400 gesteuert, die bevorzugt eine Look-Up-Tabelle 1410 aufweist.

Die Windenergieanlagen 1000 (kurz: WEA_i) werden durch die Windparksteuereinheit 1400 über eine Windenergieanlagensteuereinheit gesteuert, bspw. mittels eines Blindleistungssollwertes Q_SOLL_WEA_i und erzeugen hierdurch jeweils eine elektrische Wirkleistung P_WEA_i und eine elektrische Blindleistung Q_WEA_i.

Diese so erzeugten Wirk- und Blindleistung P_WEA_i, Q_WEA_i werden über einen Umrichter in das elektrische Windparknetz 1200 verlustbehaftet eingespeist, d.h. der Umrichter erzeugt einen Umrichterverluster P_V_LS_i.

Je nach vorherrschendem Wind, weist jede Windenergieanlage zudem eine verfügbare Leistung P_AVAIL_WEA_i auf, die auch als verfügbare Windenergieanlagenleistung bezeichnet werden kann.

Die verfügbare Windenergieanlagenleistung P_AVAIL_WEA _i liegt zumeist über der erzeugten Leistung P_WEA_i.

Die von den Windenergieanlagen 1100 so erzeugten Leistungen P_WEA_i, Q_WEA_i werden über das elektrische Windparknetz 1200, und insbesondere am Netzanschlusspunkt 1300 über einen Transformator, in Form eines einzuspeisenden Windparkstromes I_NVP, in das elektrische Versorgungsnetz 2000 verlustbehaftet eingespeist, d.h. insbesondere, dass das Windparknetz einen Blindleistungsbedarf Q_PARK_ZUS mit einer Verlustleitung P_V_PARK aufweist.

Das Windparknetz selbst kann hier durch einen Windparkwiderstand R_PARK, jX_PARK beschrieben werden.

Zum Steuern des Windparks 1000 wird eine Windparksteuereinheit 1400 verwendet, die dazu eingerichtet ist, über die Windenergieanlagensteuereinheit mit den einzelnen Windenergieanlagen zu kommunizieren und diesen Sollwert, wie bspw. einem Blindleistungssollwert Q_SOLL_WEA_i, zu übergeben.

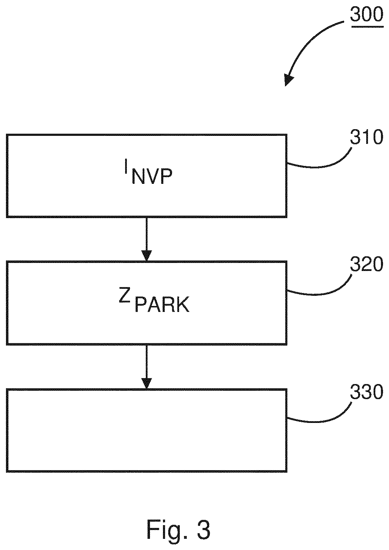

Fig. 3 zeigt schematisch und exemplarisch den Ablauf 300 eines Verfahrens zum Bestimmen einer Verlustleistung eines Windparks, insbesondere wie in Fig. 2 gezeigt.

In einem ersten Schritt 310 wird ein, durch den Windpark am Netzanschlusspunkt, einzuspeisender Strom bestimmt, bspw. aus einem Sollwert.

In einem weiteren Schritt 320 wird ein Windparkwiderstand des Windparks bestimmt, durch den der einzuspeisende Strom fließt, bspw. durch Kenndaten des Windparks.

In einem weiteren Schritt 330 wird die Verlustleistung des Windparks unter Berücksichtigung des einzuspeisenden Stromes und des Windparkwiderstands bestimmt.

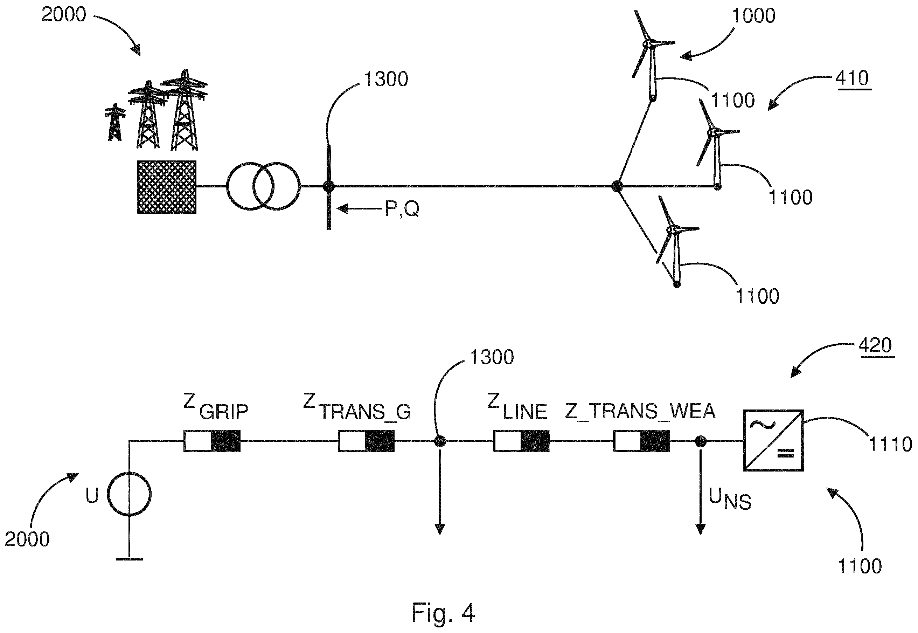

Fig. 4 zeigt schematisch und exemplarisch ein vereinfachtes Ersatzschaltbild eines Windparks, wie bspw. in Fig. 2 gezeigt.

Im oberen Teil 410 ist eine technische Abbildung eines Windparks 1000 mit einer Vielzahl von Windenergieanlagen 1100 zu sehen, der über einen Netzanschlusspunkt 1300 an einem Transformator mit dem elektrischen Versorgungsnetz 2000 verbunden ist.

Der Netzanschlusspunkt 1300 wird bevorzugt durch den Netzbetreiber vorgegeben, bspw. vor, hinter oder im Transformator.

Im unteren Teil 420 ist das entsprechende, insbesondere einphasige, Ersatzschaltbild abgebildet, welches vom elektrischen Versorgungsnetz 2000 bis zum Umrichter 1110 der Windenergieanlage 1100 reicht.

Es werden zur Bestimmung der Verlustleistung des Windparks P_V_GES, insbesondere der Windparkwiderstand Z_PARK, bevorzugt von der Niederspannungsseite U_NS der Windenergieanlage, insbesondere am Ausgang des Umrichters 1110, bis zum Netzanschlusspunkt 1300, und bevorzugt die Impedanz Z_grid des überlagerten Netzes berücksichtigt. Die Verlustleistung des Windparks P_V_GES wird also insbesondere aus der Verlustleistung des Windparknetzes P_V_PARK und den zusätzlichen Umrichterverlusten der Windenergieanlagen P_V_LS_i bestimmt. Das Ganze erfolgt insbesondere unter Verwendung der Ladeblindleistung Q_KAP des Windparks, bevorzugt bei einer Wirkleistung von Null.

In einem ersten Schritt wird also bspw. die Verlustleistung des Windparknetzes bestimmt, bevorzugt durch ein einphasiges Ersatzschaltbild mittels der Gleichung: ${P}_{V _ PARK} = {I}_{PARK}^{2} ∗ \frac{{R}_{PARK}}{3} .$

In einem weiteren Schritt wird der Blindleistungsbedarf des Windparknetzes bei Null Wirkleistung bestimmt, bspw. mittels der Gleichung: ${Q}_{PARK} \left(P=0\right) = {I}_{PARK}^{2} ∗ \frac{{X}_{PARK}}{3} - {Q}_{KAP} \left(P=0\right) .$

Anschließend können hieraus die zusätzlichen Umrichterverluste P_V_LS_i bestimmt werden, bspw. über die Hilfsgröße tan(φ)_LS mit $tan {\left(φ\right)}_{LS} = \frac{{Q}_{NVP} + {Q}_{PARK}}{{P}_{NVP} + {P}_{V _ PARK}} ,$ so dass sich die zusätzlichen Umrichterverluste P_V_LS_i ergeben aus: ${P}_{V _ LS _ i} = {I}_{NVP} ∗ \left(\sqrt{1 + tan {\left(φ\right)}^{2}}-1\right) ∗ {U}_{Nenn} ∗ \left(1-eta\right) ,$ wobei U_Nenn die Nennspannung des Windparks, insbesondere am Anschlusspunkt der Windenergieanlage am Windparknetz oder am Netzanschlusspunkt des Windparks, und eta den Wirkungsgrad des Umrichters der Windenergieanlage im Nennpunkt beschreibt.

Es wird insbesondere also auch vorgeschlagen, die zusätzlichen Wirkleistungsverluste in Abhängigkeit des Wirkungsgrades der Umrichter zu berücksichtigen.

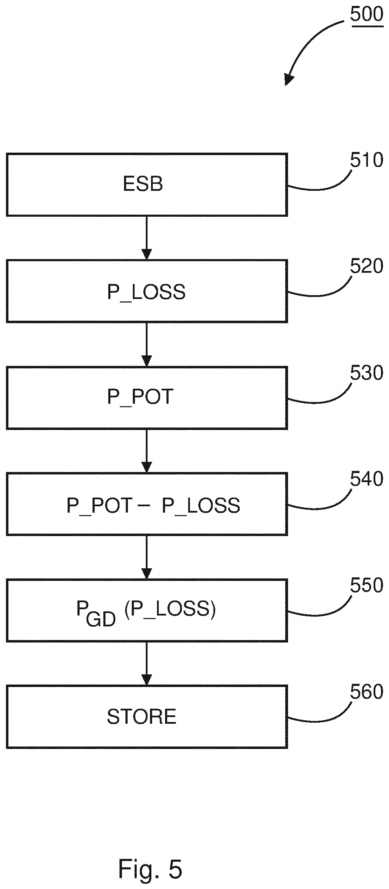

Fig. 5 zeigt schematisch und exemplarisch den Ablauf 500 eines Verfahrens zum Bestimmen einer verfügbaren Leistung in einer Ausführungsform.

In einem ersten Schritt 510 wird ein Ersatzschaltbild für den Windpark bestimmt.

In einem weiteren Schritt 520 wird die Verlustleistung des Windparks bestimmt, bevorzugt wie vorstehend beschrieben.

In einem weiteren Schritt 530 wird die maximal möglich Leistung des Windparks unter Berücksichtigung eines vorherrschenden Windes beschrieben.

In einem weiteren Schritt 540 wird die verfügbare Leistung des Windparks bestimmt. Hierzu wird von der maximal möglichen Leistung des Windparks die Verlustleistung abgezogen.

Die hieraus ermittelte Leistung wird in einem weiteren Schritt 550 unter Berücksichtigung von weiteren Verlusten an den Netzbetreiber gemeldet bzw. zur für Verfügung gestellt.

Zudem wird dieser Zustand in einem weiteren Schritt 560 abgespeichert, bspw. um eines der vorstehend beschriebenen Verfahren iterativ auszuführen.

### Bezugszeichenliste

- 100: Windenergieanlage
- 300: Ablauf eines Verfahrens zum Bestimmen einer Verlustleistung
- 310: Schritt: Bestimmen eines einzuspeisenden Stromes
- 320: Schritt: Bestimmen eines Windparkwiderstandes
- 330: Schritt: Bestimmen einer Verlustleistung
- 500: Ablauf eines Verfahrens zum Bestimmen einer verfügbaren Leistung
- 510: Schritt: Bestimmen eines Ersatzschaltbildes
- 520: Schritt: Bestimmen einer Verlustleistung
- 530: Schritt: Bestimmen einer maximal möglichen Leistung
- 540: Schritt: Bestimmen einer verfügbaren Leistung
- 550: Schritt: Melden einer verfügbaren Leistung an den Netzbetreiber
- 560: Schritt: Speicher für iteratives Verfahren
- 1000: Windpark
- 1100: Windenergieanlage, insbesondere des Windparks
- 1110: Umrichter, insbesondere der Windenergieanlage
- 1200: Windparknetz, insbesondere des Windparks
- 1300: Netzanschlusspunkt, insbesondere des Windparks
- 1400: Windparksteuereinheit, insbesondere des Windparks
- 1410: Look-Up-Tabelle, insbesondere der Windparksteuereinheit
- 2000: elektrisches Versorgungsnetz
- A_Q_WEA_i: Blindleistungsarbeitungspunkt der Windenergieanlagen
- A_Q_WPP: Blindleistungsarbeitspunkt des Windparks
- FCU: Windparksteuereinheit
- Q(F)_NVP: Blindleistungsfahrweise am Netzanschlusspunkt
- Q(U): Blindleistungs-Spannungskurve
- GRID: elektrisches Versorgungsnetz
- I_NVP: eingespeister Strom des Windparks am Netzanschlusspunkt
- jX_PARK: Windparkwiderstand, Imaginärteil
- k_1, 2, 3, ...: Faktor
- LS_i: Umrichter einer Windenergieanlage
- NVP: Netzanschlusspunkt
- p: relative Verluste
- PARK: elektrisches Windparknetz
- P_WEA_i: elektrische Wirkleistung einer Windenergieanlage
- P_avail_WEA_i: verfügbare Leistung der Windenergieanlage
- P_avail_PARK: verfügbare Leistung des Windparks
- P_V_LS_i: zusätzlichen Umrichterverluste der Windenergieanlagen
- P_V_GES: Verlustleistung des Windparks
- P_V_PARK: Verlustleitung des Windparknetzes
- Q_KAP: Ladeblindleistung des Windparknetzes
- Q_Soll_WEA_i: Blindleistungssollwert der Windenergieanlage
- Q_WEA_i: elektrische Blindleistung einer Windenergieanlage
- Q_PARK: Blindleistungsbedarf des elektrischen Windparknetzes
- R_PARK: Windparkwiderstand, Realteil
- tan(φ): Hilfsgröße
- Z_PARK: Windparkwiderstand
- z_grid: Netzimpedanz
- z_trans_g: Stichimpedanz
- z_line: Impedanz der Verbindungsleitung
- z_trans_wea: Impedanz des Windenergieanlagentransformators
- WEA_i: Windenergieanlage
- WPP: Windpark

## Patentansprüche

1. Verfahren zum Bestimmen einer verfügbaren Leistung eines, an einem Netzanschlusspunkt (1300) eines elektrischen Versorgungsnetzes (2000) angeschlossenen Windparks (1000), wobei der Windpark (1000) eine Vielzahl von Windenergieanlagen (1100) aufweist, die gemeinsam über ein elektrisches Windparknetz (1200) verbunden sind und jeweils einen Umrichter (1110) zum Einspeisen elektrischer Leistung (P_WEA_i; Q_WEA_i) in das elektrische Windparknetz (1200) aufweisen,
umfassend die Schritte:
- Bestimmen einer verfügbaren Leistung der Windenergieanlage (P_avail_WEA_i) unter Berücksichtigung eines vorherrschenden Windes,
- Berechnen der verfügbaren Leistung des Windparks (P_avail_Park) unter Berücksichtigung einer Verlustleistung des Windparks (P_V_GES), und das Bestimmen der Verlustleistung umfasst die Schritte
- Bestimmen eines, durch den Windpark (1000) am Netzanschlusspunkt (1300) einzuspeisenden Stromes (I_NVP);
- Bestimmen eines Windparkwiderstands (Z_PARK) des Windparks (1000) durch den der einzuspeisende Strom (I_NVP) fließt;
- Bestimmen der Verlustleistung des Windparks (P_V_GES) unter Berücksichtigung des einzuspeisenden Stromes (I_NVP) und des Windparkwiderstands (Z_PARK).

2. Verfahren zum Bestimmen einer verfügbaren Leistung eines, eine Vielzahl von Windenergieanlagen aufweisenden Windparks (P_avail_Park) nach Anspruch 1, wobei
- das Berechnen der verfügbaren Leistung des Windparks (P_avail_Park) auch unter Berücksichtigung einer verfügbaren Wirkleistung (P_avail_wea_i) der Windenergieanlagen erfolgt.

3. Verfahren zum Bestimmen einer verfügbaren Leistung nach Anspruch 1 oder 2, wobei
- der einzuspeisende Strom (I_NVP) in Abhängigkeit der verfügbaren Leistung des Windparks (P_avail_WPP) bestimmt wird.

4. Verfahren zum Bestimmen einer verfügbaren Leistung nach einem der vorstehenden Ansprüche , ferner umfassend den Schritt:
- Bestimmen einer Spannung (U_NVP) am Netzanschlusspunkt (1300); und wobei
- der einzuspeisende Strom (I_NVP) in Abhängigkeit der Spannung (U_NVP) am Netzanschlusspunkt bestimmt wird.

5. Verfahren zum Bestimmen einer verfügbaren Leistung nach einem der vorstehenden Ansprüche, wobei der Windparkwiderstand (Z_PARK) den Windpark (1000) vom Netzanschlusspunkt aus beschreibt.

6. Verfahren zum Bestimmen einer verfügbaren Leistung nach einem der vorstehenden Ansprüche, wobei
- das Bestimmen der Verlustleistung des Windparks (P_V_GES) unter Verwendung eines vereinfachten Ersatzschaltbildes für den Windpark erfolgt, insbesondere mit einem einphasigen Ersatzschaltbild, welches bevorzugt zur Bestimmung der Verlustleistung des Windparknetzes P_V_PARK verwendet wird.

7. Verfahren zum Bestimmen einer verfügbaren Leistung nach einem der vorstehenden Ansprüche, wobei
- das Bestimmen der Verlustleistung des Windparks (P_V_GES) unter Berücksichtigung eines Blindleistungsarbeitspunktes (A_Q_WPP) des Windparks (1000) erfolgt.

8. Verfahren zum Bestimmen einer verfügbaren Leistung nach einem der vorstehenden Ansprüche, wobei
- das Bestimmen der Verlustleistung des Windparks (P_V_GES) unter Berücksichtigung einer Spannungssensitivität (U(P)), insbesondere am Netzanschlusspunkt (1300), erfolgt.

9. Verfahren zum Bestimmen einer verfügbaren Leistung nach einem der vorstehenden Ansprüche, wobei
- das Bestimmen der Verlustleistung des Windparks (P_V_GES) erfolgt für eine Ladeblindleistung bei null Wirkleistung.

10. Verfahren zum Bestimmen einer verfügbaren Leistung nach einem der vorstehenden Ansprüche, ferner umfassend den Schritt:
- Bestimmen von zusätzlichen Umrichterverlusten der Windenergieanlage (P_V_LS_i), wobei
- das Bestimmen der Verlustleistung des Windparks (P_V_GES) auch unter Berücksichtigung der zusätzlichen Umrichterverluste der Windenergieanlagen erfolgt.

11. Verfahren zum Steuern eines Windparks, umfassend die Schritte:
- Steuern des Windparks unter Berücksichtigung einer verfügbaren Leistung (P_avail_Park) des Windparks, die nach einem Verfahren nach Anspruch 1 bis 10 berechnet wurde.

12. Windpark (1000) umfassend eine Vielzahl von Windenergieanlagen (1100) und eine Windparksteuereinheit (1200), wobei die Windparksteuereinheit dazu eingerichtet ist, ein Verfahren nach einem der Ansprüche 1 bis 10und/oder 11 auszuführen.

13. Windpark (1000) nach Anspruch 12, wobei die Windparksteuereinheit eine Look-Up-Tabelle aufweist.

## Claims

1. A method for determining the available power of a wind farm (1000) connected to a grid connection point (1300) of an electrical power grid (2000), wherein the wind farm (1000) comprises a plurality of wind turbines (1100) that are collectively connected via an electrical wind farm grid (1200) and each have an inverter (1110) for feeding electrical power (P_WEA_i; Q_WEA_i) into the wind farm electrical grid (1200),
comprising the steps:
- determining an available power of the wind turbine (P_avail_WEA_i) taking into account a prevailing wind,
- calculating the available power of the wind farm (P_avail_Park) taking into account power losses in the wind farm (P_V_GES), and determining the power losses comprises the steps
- Determining a current (I_NVP) to be fed into the grid by the wind farm (1000) at the grid connection point (1300);
- Determining a wind farm impedance (Z_PARK) of the wind farm (1000) through which the current to be fed into the grid (I_NVP) flows;
- Determining the power loss of the wind farm (P_V_GES), taking into account the current to be fed into the grid (I_NVP) and the wind farm impedance (Z_PARK).

2. A method for determining the available power (P_avail_Park) of a wind farm comprising a plurality of wind turbines, as claimed in claim 1, wherein
- the calculation of the available power of the wind farm (P_avail_Park) is also performed taking into account the available active power (P_avail_wea_i) of the wind turbines.

3. A method for determining an available power according to claim 1 or 2, wherein
- the current to be fed into the grid (I_NVP) is determined as a function of the available power of the wind farm (P_avail_WPP).

4. A method for determining an available power output according to any of the preceding claims, further comprising the step:
- determining a voltage (U_NVP) at the grid connection point (1300); and wherein
- the current to be fed into the grid (I_NVP) is determined as a function of the voltage (U_NVP) at the grid connection point.

5. A method for determining available power according to one of the preceding claims, wherein the wind farm impedance (Z_PARK) characterizes the wind farm (1000) as viewed from the grid connection point.

6. A method for determining available power according to one of the preceding claims, wherein
- the determination of the power loss of the wind farm (P_V_GES) is performed using a simplified equivalent circuit for the wind farm, in particular a single-phase equivalent circuit, which is preferably used to determine the power loss of the wind farm network P_V_PARK.

7. A method for determining available power according to one of the preceding claims, wherein
- the determination of the power loss of the wind farm (P_V_GES) is performed taking into account a reactive power operating point (A_Q_WPP) of the wind farm (1000).

8. A method for determining available power according to one of the preceding claims, wherein
- the power loss of the wind farm (P_V_GES) is determined taking into account a voltage sensitivity (U(P)), in particular at the grid connection point (1300).

9. A method for determining available power according to one of the preceding claims, wherein
- the determination of the power loss of the wind farm (P_V_GES) is performed for a reactive load power at zero active power.

10. A method for determining available power according to one of the preceding claims, further comprising the step of:
- determining additional inverter losses of the wind turbine (P_V_LS_i), wherein
- the determination of the power loss of the wind farm (P_V_GES) is also performed taking into account the additional converter losses of the wind turbines.

11. A method for controlling a wind farm, comprising the steps of:
- controlling the wind farm while taking into account an available power (P_avail_Park) of the wind farm, which was calculated according to a method according to claims 1 through 10.

12. A wind farm (1000) comprising a plurality of wind turbines (1100) and a wind farm control unit (1200), wherein the wind farm control unit is configured to execute a method according to any one of claims 1 through 10 and/or 11.

13. A wind farm (1000) according to claim 12, wherein the wind farm control unit comprises a look-up table.

## Revendications

1. Procédé de détermination d'une puissance disponible d'un parc éolien (1000) raccordé à un point de raccordement au réseau (1300) d'un réseau d'alimentation électrique (2000), dans lequel le parc éolien (1000) présente une pluralité d'éoliennes (1100) connectées ensemble via un réseau de parc éolien (1200) et présentant chacune un convertisseur (1110) pour l'alimentation en puissance électrique (P_WEA_i ; Q_WEA_i) dans le réseau de parc éolien (1200),
comprenant les étapes suivantes :
- déterminer une puissance disponible de l'éolienne (P_avail_WEA_i) en tenant compte d'un vent prédominant,
- calculer la puissance disponible du parc éolien (P_avail_Park) en tenant compte d'une puissance dissipée du parc éolien (P_V_GES) et la détermination de la puissance dissipée comprend les étapes suivantes
- déterminer un courant (l_NVP) à alimenter par le parc éolien (1000) au point de raccordement au réseau (1300) ;
- déterminer une résistance de parc éolien (Z_PARK) du parc éolien (1000) à travers laquelle circule le courant (l_NVP) à alimenter ;
- déterminer la puissance dissipée du parc éolien (P_V_GES) en tenant compte du courant (l_NVP) à alimenter et de la résistance du parc éolien (Z_PARK).

2. Procédé de détermination d'une puissance disponible d'un parc éolien (P_avail_Park) présentant une pluralité d'éoliennes selon la revendication 1, dans lequel
- le calcul de la puissance disponible du parc éolien (P_avail_Park) s'effectue également en tenant compte d'une puissance active disponible (P_avail_wea_i) des éoliennes.

3. Procédé de détermination d'une puissance disponible selon la revendication 1 ou 2, dans lequel
- le courant (l_NVP) à alimenter est déterminé en fonction de la puissance disponible du parc éolien (P_avail_WPP).

4. Procédé de détermination d'une puissance disponible selon l'une quelconque des revendications précédentes, comprenant en outre l'étape suivante :
- déterminer une tension (U_NVP) au point de raccordement au réseau (1300) ; et dans lequel
- le courant (l_NVP) à alimenter est déterminé en fonction de la tension (U_NVP) au point de raccordement au réseau.

5. Procédé de détermination d'une puissance disponible selon l'une quelconque des revendications précédentes, dans lequel la résistance de parc éolien (Z_PARK) définit le parc éolien (1000) à partir du point de raccordement au réseau.

6. Procédé de détermination d'une puissance disponible selon l'une quelconque des revendications précédentes, dans lequel
- la détermination de la puissance dissipée du parc éolien (P_V_GES) s'effectue à l'aide d'un schéma de remplacement simplifié pour le parc éolien, en particulier avec un schéma de remplacement monophasé, qui est utilisé de préférence pour déterminer la puissance dissipée du réseau du parc éolien P_V_PARK.

7. Procédé de détermination d'une puissance disponible selon l'une quelconque des revendications précédentes, dans lequel
- la détermination de la puissance dissipée du parc éolien (P_V_GES) s'effectue en tenant compte d'un point de travail de puissance réactive (A_Q_WPP) du parc éolien (1000).

8. Procédé de détermination d'une puissance disponible selon l'une quelconque des revendications précédentes, dans lequel
- la détermination de la puissance dissipée du parc éolien (P_V_GES) s'effectue en tenant compte d'une sensibilité à la tension (U(P)), notamment au point de raccordement au réseau (1300).

9. Procédé de détermination d'une puissance disponible selon l'une quelconque des revendications précédentes, dans lequel
- la détermination de la puissance dissipée du parc éolien (P_V_GES) s'effectue pour une puissance réactive de charge à puissance active nulle.

10. Procédé de détermination d'une puissance disponible selon l'une quelconque des revendications précédentes, comprenant en outre l'étape suivante :
- déterminer les pertes supplémentaires de convertisseur de l'éolienne (P_V_LS_i), dans lequel
- la détermination de la puissance dissipée du parc éolien (P_V_GES) s'effectue également en tenant compte des pertes supplémentaires de convertisseur des éoliennes.

11. Procédé de commande d'un parc éolien, comprenant les étapes suivantes :
- commander le parc éolien en tenant compte d'une puissance disponible (P_avail_Park) du parc éolien calculée selon un procédé selon les revendications 1 à 10.

12. Parc éolien (1000) comprenant une pluralité d'éoliennes (1100) et une unité de commande de parc éolien (1200), dans lequel l'unité de commande de parc éolien est configurée pour exécuter un procédé selon l'une quelconque des revendications 1 à 10 et/ou 11.

13. Parc éolien (1000) selon la revendication 12, dans lequel l'unité de commande de parc éolien présente un tableau de consultation.
